# NEUE EUROPÄISCHE PATENTSCHRIFT

(11) **EP 2 316 255 B2**
(45) Veröffentlichungstag und Bekanntmachung des Hinweises auf die Entscheidung über den Einspruch: **14.01.2015**
(45) Hinweis auf die Patenterteilung: 16.11.2011
(21) Anmeldenummer: 10773229.9
(22) Anmeldetag: 27.08.2010
(51) Int. Cl.: H05K 7/20

(54) **ISOLIERSYSTEM FÜR RECHENZENTRUM**
INSULATION SYSTEM FOR A DATA CENTRE
SYSTEME D'ISOLATION POUR CENTRE DE CALCUL

(30) Priorität: 28.08.2009 DE 102009039014; 31.08.2009 DE 102009039315; 19.01.2010 DE 102010005141
(43) Veröffentlichungstag der Anmeldung: 04.05.2011
(60) Teilanmeldung: 11008081.9
(73) Patentinhaber: Hanno-Werk GmbH & Co. KG, 30880 Laatzen (DE)
(72) Erfinder: HEIDENBERGER, Dirk, 25482 Appen (DE); HOFFMANN, Hans, J., 31157 Sarstedt (DE)
(74) Vertreter: Patentanwälte Thömen & Körner
(86) Internationale Anmeldenummer: PCT/DE2010/000997
(87) Internationale Veröffentlichungsnummer: WO 2011/023174

(56) Entgegenhaltungen:
- EP-A1- 0 208 227
- EP-A1- 0 694 574
- EP-A2- 1 808 454
- WO-A1-2008/037600
- WO-A1-2008/127344
- DE-A1-102006 050 939
- DE-U1- 29 704 602
- DE-U1-202006 001 050
- JP-A- 2010 133 637
- US-A- 3 325 954
- US-A1- 2003 050 003
- US-A1- 2008 185 446
- US-A1- 2009 129 000
- US-A1- 2010 190 430
- US-B2- 6 497 739
- US-B2- 7 841 199
- Publikation INTERFACE online, Spring 2008, Nr. 240, veröffentlicht vom Center for Information Technology, National Institute of Health

## Beschreibung

Die Erfindung betrifft ein Isoliersystem für ein Rechenzentrum nach dem Oberbegriff des Anspruchs 1.

Ein solches System ist aus der Publikation INTERFACE online, Spring 2008, Nr. 240, veröffentlicht vom Center for Information Technology, National Institute of Health, bekannt.

Aus der US 6,672,955 B2 ist ein Kühlsystem für ein Rechenzentrum bekannt, bei welchem den in Geräte- und/oder Serverschrankreihen aufgenommenen elektronischen Geräten, insbesondere Servern, Kaltluft aus einem so genannten Kaltgang zugeführt wird. Die Kaltluft, die in einem Wärmetauscher außerhalb des Rechnerraums gekühlt wird, gelangt hierbei mit Hilfe von Gebläsen in einen Doppelboden des Rechnerraums und dann gezielt über vorgegebene bodenseitige Öffnungen in den Kaltgang.

Der Boden eines Rechenzentrums ist meist aufgeständert, um in diesem Leitungen und kalte Luft bzw. Kaltluft zu führen. Im allgemeinen Sprachgebrauch spricht man von einem Doppelboden. Da in diesen Doppelboden Kaltluft eingebracht wird, kann der Doppelboden auch als Druckboden bezeichnet werden.

Ausgehend von diesem Stand der Technik liegt der Erfindung die Aufgabe zugrunde, die im Rechenzentrum vorgesehene Kühlung noch effizienter auszugestalten und insbesondere die Energiekosten im Rechenzentrum deutlich zu senken.

Diese Aufgabe wird erfindungsgemäß durch ein Isoliersystem nach dem Oberbegriff des Anspruchs 1 durch das kennzeichnende Merkmal des Anspruchs 1 gelöst. Weitere vorteilhafte Ausführungsformen ergeben sich aus den Unteransprüchen und der Beschreibung.

Das Isoliersystem für ein Rechenzentrum umfasst einen Rechnerraum mit Geräte- oder Serverschrankreihen, deren Geräte- oder Serverschränke auf einem Doppelboden positioniert sind, wobei bodenseitige Lufteinström- bzw. Lufteinsaugöffnungen, die nicht für die gezielte Zufuhr von Kaltluft vorgesehen sind, erfindungsgemäß mit einem Schaumstoff versehen sind.

Um eine hohe Dichtigkeit zu erhalten, ist erfindungsgemäß vorgesehen, dass der Schaumstoff ein Melaminharzschaum ist, wobei dieser eine glatte oder vorzugsweise eine geprägte Oberflächenverdichtung aufweist. Melaminharzschaum ist ein flexibler, offenzelliger und sehr leichter Weichschaumstoff. Er besitzt eine hohe Schallabsorption und ist temperaturbeständig. Aufgrund der feinzelligen Struktur besitzt Melaminharzschaum bei Normaltemperatur eine relativ geringe Wärmeleitfähigkeit, so dass die im Doppelboden geführte Kaltluft nicht erwärmt wird. Melaminharzschaum eignet sich somit besonders zur thermischen Isolierung. Vorteilhaft ist zudem, dass Melaminharzschaum die Baustoffklasse B1 erfüllt und nur schwer entflammbar ist.

Dadurch, dass die nicht für die gezielte Zufuhr von Kaltluft vorgesehenen Lufteinström- bzw. Lufteinsaugöffnungen mit dem Melaminharzschaum versehen sind, wird eine Dichtheit und thermische Isolierung des Doppelbodens erreicht, wobei die im Doppelboden geführte Kaltluft im Wesentlichen nur durch die tatsächlich dafür vorgesehenen Öffnungen strömt. Hierzu sind die Lufteinström- bzw. Lufteinsaugöffnungen vorzugsweise möglichst dicht mit dem Schaumstoff verschlossen.

Dadurch wird auf erstaunlich einfache Weise eine erhebliche Energiekosteneinsparung in einem Rechenzentrum erreicht. Der Erfindung liegt dabei die Erkenntnis zugrunde, dass die genannten Lufteinström- bzw. Lufteinsaugöffnungen sowie andere unerwünschte Auslässe im Doppelboden zu einem unerwünschten Kaltluftdruckabfall innerhalb des Doppelbodens eines Rechnerraums führen. Dadurch, dass solche Öffnungen erfindungsgemäß mittels Melaminharzschaum verschlossen bzw. dicht oder zumindest dichter gemacht sind, kann der gewünschte Kaltluftdruck im Doppelboden mit weniger energetischen Aufwand der Kaltluft erzeugenden Quelle(n) und der den Kaltluftdruck herstellenden Mittel(n) betrieben werden. Es wird auf einfache Weise eine effektive thermische Isolierung des Doppelbodens erreicht, wobei der Schaumstoff gleichzeitig vorteilhaft schallabsorbierend wirkt.

Die Montage des Schaumstoffs in einer Lufteinström- bzw. Lufteinsaugöffnung ist hierbei außerordentlich einfach und kostenfreundlich, wobei der Schaumstoff ein Weichschaum ist, der insbesondere händisch durch Zusammendrücken in einen komprimierten Zustand bringbar ist und sich nach dem Loslassen wieder ausdehnt bzw. expandiert.

Bei den Lufteinström- bzw. Lufteinsaugöffnungen kann es sich vorzugsweise um solche zur Durchführung diverser Leitungen und/oder Installationsmaterialien, insbesondere solche zur Durchführung von Kabeln, ganz besonders solche zur Durchführung einer Server- und/oder Netzwerkverkabelung, handeln. Insbesondere kann es sich um solche Lufteinström- bzw. Lufteinsaugöffnungen handeln, die bereits im Doppelboden vorhanden sind, aber für die die Durchführung diverser Leitungen und/oder Installationsmaterialien erst später geplant ist.

Ganz allgemein handelt es sich bei den Lufteinström- bzw. Lufteinsaugöffnungen um solche, die zu unerwünschten Druckverlusten im Doppelboden führen. Dabei können diese Lufteinström- bzw. Lufteinsaugöffnungen geplant in den Doppelboden eingebracht sein oder ungewollt.

Vorzugsweise werden solche Lufteinström- bzw. Lufteinsaugöffnungen mit Schaumstoff versehen, die in den, den Doppelboden bildenden Platten, insbesondere als Lochausschnitt, oder angrenzend an die, den Doppelboden bildenden Platten, insbesondere als Ausschnitt im Randbereich oder durch Fehlen einer oder mehrerer Platten im Randbereich, angeordnet sind.

Eine Weiterbildung der Erfindung sieht vor, dass der Schaumstoff kugel-, kissen-, vorzugsweise jedoch plattenförmig ausgebildet ist.

Um den Schaumstoff auf einfachste Weise der Form der Lufteinström- bzw. Lufteinsaugöffnung anzupassen und vorhandene Leitungen zu umschließen, kann es vorteilhaft sein, wenn der Schaumstoff vorzugsweise in einzelne Rechtecke, besonders bevorzugt in einzelne Quadrate, vorgestanzt bzw. perforiert ist. Diese können entnommen, wiedereingesetzt oder zur Aufnahme einer oder mehrer Leitungen und/oder Installationsmaterialien kurzfristig voneinander getrennt werden. Der Ausgangsschaumstoff hat vorzugsweise Abmessungen von 620 mm x 620 mm x 50 mm. Mit einem solchen Schaumstoff lassen sich üblicherweise alle in einem Rechnerraum unerwünschten Lufteinström- bzw. Lufteinsaugöffnung verschließen. Kleinere Abmessungen oder andere Formen können durch einfaches Teilen entlang der Perforierungen bzw. Vorstanzungen des Schaumstoffs hergestellt werden.

Die Lufteinström- bzw. Lufteinsaugöffnung können unterschiedlichste Formen haben. Sie können beispielsweise rund oder eckig ausgebildet sein.

Eine Weiterbildung der Erfindung sieht vor, dass der Schaumstoff schwer- oder nicht entflammbar ist.

Für gewisse Gebrauchsfälle kann es von Vorteil sein, wenn der Schaumstoff Mineral-Glas-Keramikwolle aufweist. Für andere gewisse Gebrauchsfälle kann es von Vorteil sein, wenn der Schaumstoff ein Schaum- oder Blähglas aufweist. Für andere bestimmte Gebrauchsfälle kann es von Vorteil sein, wenn der Schaumstoff Perlit oder Blähperlit, Silikat, Blähglimmer- oder Blähton, oder Bims aufweist.

Für bestimmte Verwendungsfälle kann es von Vorteil sein, wenn der Schaumstoff wenigstens eine Metallfolie, vorzugsweise eine Aluminiumfolie, aufweist. Für wieder andere bestimmte Verwendungsfälle kann es von Vorteil sein, wenn der Schaumstoff wenigstens eine Kunststofffolie aufweist. Für noch andere bestimmte Verwendungsfälle kann es von Vorteil sein, wenn der Schaumstoff eine Bitumenbeschichtung aufweist.

Schränke werden meist einheitlich so bestückt, dass die Gerätefronten auf einer Seite des Schrankes angeordnet sind. Dadurch soll erreicht werden, dass die Geräte einheitlich auf einer Seite die zur Kühlung bestimmte Kaltluft ansaugen und die erwärmte Luft einheitlich auf einer anderen, üblicherweise gegenüberliegenden Seite wieder abgeben.

Es kann vorteilhaft sein, wenn Öffnungen der Front- und Rückseite, aber auch der linken und/oder rechten Seitenteile sowie des Daches einer teilweise leeren bzw. vollständig leeren, also mit einem kleineren elektronischen Gerät bzw. ohne elektronischem Gerät versehenen Aufnahme eines Geräte- oder Serverschrankes, mit dem Schaumstoff versehen sind. Die mit dem Schaumstoff vorzugsweise möglichst dicht zu machenden Öffnungen dienen hierbei nicht der gezielten Durchführung von Kaltluft durch den Geräte- oder Serverschrank. Dadurch werden Klimaverluste durch beispielsweise unerwünschte Vermischungen oder Verwirbelungen von warmer und kalter Luft im Geräte- oder Serverschrank vermieden. Der Geräte- oder Serverschrank kann so auf einfache, insbesondere montagefreundliche Weise, thermisch isoliert werden. Insgesamt wird die erforderliche Kühlung noch effizienter ausgestaltet. Der Schaumstoff lässt sich hierbei äußerst flexibel den Gegebenheiten anpassen.

Für einige Einsatzfälle kann es von Vorteil sein, wenn die Oberfläche des Schaumstoffs zusätzlich imprägniert ist. Für einige andere Einsatzfälle kann es von Vorteil sein, wenn die Oberfläche des Schaumstoffs zusätzlich beschichtet ist, wobei die Beschichtung vorzugsweise eine Kunststoffbeschichtung und/oder besonders bevorzugt eine Brandschutzbeschichtung ist oder aufweist.

## Patentansprüche

1. Isoliersystem für ein Rechenzentrum, umfassend einen Rechnerraum mit Geräte- oder Serverschrankreihen, deren Geräte- oder Serverschränke auf einem Doppelboden positioniert sind, wobei bodenseitige Lufteinström- bzw. Lufteinsaugöffnungen, die nicht für die gezielte Zufuhr von Kaltluft vorgesehen sind, mit einem Schaumstoff versehen sind, **dadurch gekennzeichnet, dass** der Schaumstoff ein Melaminharzschaum ist und eine glatte oder vorzugsweise eine geprägte Oberflächenverdichtung aufweist.

2. Isoliersystem nach Anspruch 1, **dadurch gekennzeichnet, dass** die Lufteinström- bzw. Lufteinsaugöffnungen solche zur Durchführung diverser Leitungen und/oder Installationsmaterialen, insbesondere solche zur Durchführung von Kabeln, ganz besonders solche zur Durchführung einer Server- und/oder Netzwerkverkabelung, sind.

3. Isoliersystem nach Anspruch 1 oder 2, **dadurch gekennzeichnet, dass** Lufteinström- bzw. Lufteinsaugöffnungen solche sind, die zu unerwünschten Druckverlusten im Doppelboden führen.

4. Isoliersystem nach einem der Ansprüche 1 bis 3, **dadurch gekennzeichnet, dass** Lufteinström- bzw. Lufteinsaugöffnungen in den, den Doppelboden bildenden Platten, insbesondere als Lochausschnitt, oder angrenzend an die, den Doppelboden bildenden Platten, insbesondere als Ausschnitt im Randbereich oder durch Fehlen einer oder mehrerer Platten, angeordnet sind.

5. Isoliersystem nach einem der Ansprüche 1 bis 4, **dadurch gekennzeichnet, dass** der Schaumstoff kugel-, kissen-, vorzugsweise jedoch plattenförmig ausgebildet ist.

6. Isoliersystem nach einem der Ansprüche 1 bis 5, **dadurch gekennzeichnet, dass** der Schaumstoff vorgestanzt bzw. perforiert ist, wobei der Schaumstoff vorzugsweise in einzelne Rechtecke, vorzugsweise Quadrate, vorgestanzt bzw. perforiert ist.

7. Isoliersystem nach einem der Ansprüche 1 bis 6, **dadurch gekennzeichnet, dass** der Schaumstoff schwer- oder nicht entflammbar ist.

8. Isoliersystem nach einem der Ansprüche 1 bis 7, **dadurch gekennzeichnet, dass** der Schaumstoff ein Weichschaum ist.

9. Isoliersystem nach einem der Ansprüche 1 bis 8, **dadurch gekennzeichnet, dass** der Schaumstoff Mineral-Glas-Keramikwolle, Schaum- oder Blähglas, Perlit oder Blähperlit, Silikat, Blähglimmer- oder Blähton, oder Bims aufweist.

10. Isoliersystem nach einem der Ansprüche 1 bis 9, **dadurch gekennzeichnet, dass** der Schaumstoff ein Vlies, vorzugsweise aus Kunst-, Natur- und/oder Mineralfasern, ein Filz, vorzugsweise aus Kunst-, Natur- und/oder Mineralfasern, wenigstens eine Metallfolie, vorzugsweise eine Aluminiumfolie oder wenigstens eine Kunststofffolie aufweist.

11. Isoliersystem nach einem der Ansprüche 1 bis 10, **dadurch gekennzeichnet, dass** der Schaumstoff eine Bitumenbeschichtung aufweist.

12. Isoliersystem nach einem der Ansprüche 1 bis 11, **dadurch gekennzeichnet, dass** Öffnungen der Front- und Rückseite, aber auch der linken und/oder rechten Seitenteile sowie des Daches eines leeren bzw. teilweise leeren, also nicht mit einem elektronischen Gerät bzw. mit einem kleineren elektronischen Gerät versehenen Faches des Aufnahmerahmens eines Geräte- oder Serverschrankes, mit dem Schaumstoff versehen sind.

13. Isoliersystem nach einem der Ansprüche 1 bis 12, **dadurch gekennzeichnet, dass** die Oberfläche des Schaumstoffsimprägniert und/oder beschichtet ist, wobei die Beschichtung vorzugsweise eine Kunststoffbeschichtung und/oder besonders bevorzugt eine Brandschutzbeschichtung ist.

## Claims

1. An insulation system for a data processing centre, comprising a data processor space with rows of device or server cabinets, of which the device or server cabinets are positioned on a double floor, wherein air-inflow or air-imbibition apertures on the floor, which are not intended for the targeted supply of cold air, are provided with a foamed material, **characterised in that** the foamed material is an melamine resin foam and has a smooth or preferably an embossed surface compaction.

2. The insulation system according to Claim 1, **characterized in that** the air-inflow or air-imbibition apertures are those for the feed-through of various leads or installation materials, in particular for the feed-through of cables, very particularly those for the feed-through of server and/or network cabling.

3. The insulation system according to Claim 1 or 2, **characterised in that** air-inflow or air-imbibition apertures are those which lead to undesired pressure losses in the double floor.

4. The insulation system according to one of claims 1 to 3, **characterised in that** air-inflow or air-imbibition apertures are arranged in the plates forming the double floor, in particular as a perforated cut-out, or adjacent the plates forming the double floor, in particular as a cut-out in the border area or through the lack of one or more plates.

5. The insulation system according to one of claims 1 to 4, **characterised in that** the foamed material is configured in a spherical or pulvinated shape, but preferably plate-shaped.

6. The insulation system according to one of claims 1 to 5, **characterised in that** the foamed material is pre-cut or perforated, wherein the foamed material is preferably pre-cut or perforated in individual rectangles, preferably squares.

7. The insulation system according to one of claims 1 to 6, **characterised in that** the foamed material is fire-resistant or non-inflammable.

8. The insulation system according to one of claims 1 to 7, **characterised in that** the foamed material is a flexible foam.

9. The insulation system according to one of claims 1 to 8, **characterised in that** the foamed material contains mineral-glass ceramic wool, foam glass or expanded glass, perlite or expanded perlite, silicate, expanded mica clay or expanded clay, or pummice.

10. The insulation system according to one of claims 1 to 9, **characterised in that** the foamed material contains a non-woven fabric, preferably made of plastic fibres, natural fibres and/or mineral fibres, a felt, preferably made of plastic fibres, natural fibres and/or mineral fibres, at least one metal foil, preferably an aluminium sheet or at least one plastic sheet.

11. The insulation system according to one of claims 1 to 10, **characterised in that** the foamed material has a bitumen coating.

12. The insulation system according to one of claims 1 to 11, **characterised in that** foamed material is provided on apertures on the front and back, but also on the left and/or right side parts as well as on the roof of an empty or partially empty shelf of the receiving frame for a device or server cabinet, i.e. a shelf of the receiving frame for a device or server cabinet whereby said shelf is not equipped with an electronic device or is only equipped with a small electronic device.

13. The insulation system according to one of claims 1 to 12, **characterised in that** the surface of the foamed materials is impregnated and/or coated, wherein the coating is preferably a plastic coating and/or particularly preferably a fireproof coating.

## Revendications

1. Système d'isolation pour un centre de calcul comprenant une salle d'ordinateurs avec des rangées d'armoires pour appareils ou serveurs, dont les armoires pour appareils ou serveurs sont positionnés sur un double-fond, les ouvertures d'entrée d'air ou d'aspiration d'air côté fond, qui ne sont pas prévues pour l'amenée ciblée d'air froid, étant pourvues d'une mousse plastique, **caractérisé en ce que** la mousse plastique est une mousse de résine mélaminique et présente une compression de surface lisse, de préférence gaufrée.

2. Système d'isolation suivant la revendication 1, **caractérisé en ce que** les ouvertures d'entrée d'air ou d'aspiration d'air sont des ouvertures servant au passage de divers fils et/ou de matériel d'installation, en particulier ceux qui servent au passage de câbles, très particulièrement ceux qui servent au passage d'un câblage de serveurs et/ou de réseaux.

3. Système d'isolation suivant la revendication 1 ou 2, **caractérisé en ce que** les ouvertures d'entrée d'air ou d'aspiration d'air sont des ouvertures qui entraînent des pertes de pression indésirables dans le double-fond.

4. Système d'isolation suivant une des revendications 1 à 3, **caractérisé en ce que** les ouvertures d'entrée d'air ou d'aspiration d'air sont disposées dans les plaques formant le double-fond, en particulier sous forme de découpe de trous, ou qu'elles sont disposées de façon adjacente aux plaques formant le double-fond, en particulier sous forme de découpe dans la zone du bord ou sous forme d'absence d'une ou de plusieurs plaques.

5. Système d'isolation suivant une des revendications 1 à 4, **caractérisé en ce que** la mousse plastique est conçu en forme de boule ou de coussin, mais de préférence en forme de plaque.

6. Système d'isolation suivant une des revendications 1 à 5, **caractérisé en ce que** la mousse plastique est prédécoupée ou perforée, la mousse plastique étant de préférence prédécoupée ou perforée en rectangles isolés, de préférence en carrés.

7. Système d'isolation suivant une des revendications 1 à 6, **caractérisé en ce que** la mousse plastique est difficilement inflammable ou ininflammable.

8. Système d'isolation suivant une des revendications 1 à 7, **caractérisé en ce que** la mousse est une mousse souple.

9. Système d'isolation suivant une des revendications 1 à 8, **caractérisé en ce que** la mousse contient de la laine de roche ou de verre ou de céramique, du verre cellulaire ou du verre expansé, de la perlite ou perlite expansée, du silicate, du mica expansé ou de l'argile expansé ou de la pierre ponce.

10. Système d'isolation suivant une des revendications 1 à 9, **caractérisé en ce que** la mousse plastique contient un non-tissé, de préférence en fibres artificielles, naturelles et/ou minérales, un feutre, de préférence en fibres artificielles, naturelles et/ou minérales, au moins une feuille métallique, de préférence une feuille d'aluminium ou au moins une feuille en matière plastique.

11. Système d'isolation suivant une des revendications 1 à 10, **caractérisé en ce que** la mousse plastique présente un revêtement en bitume.

12. Système d'isolation suivant une des revendications 1 à 11, **caractérisé en ce que** les ouvertures de la face avant et arrière, mais aussi du côté gauche et/ou droite, ainsi que du dessus d'un compartiment vide ou partiellement vide, à savoir non pourvu d'appareil électronique ou de petit appareil électronique, d'un châssis de réception d'une armoire à appareils ou à serveurs, sont pourvues de cette mousse plastique.

13. Système d'isolation suivant une des revendications 1 à 12, **caractérisé en ce que** la surface de la mousse plastique est imprégnée et/ou revêtue, le revêtement étant de préférence un revêtement en matière artificielle et/ou très préféren-tiellement un revêtement coupe-feu.
